# EUROPEAN PATENT APPLICATION

(11) **EP 4 790 095 A2**
(43) Date of publication of application: **12.08.2026**
(21) Application number: 24877539.7
(22) Date of filing: 11.10.2024
(51) Int. Cl.: C08L 63/00, C08L 79/04, C08G 59/38, C08G 59/32, C08G 59/62, C08J 5/24, H05K 1/03, B32B 15/092

(54) **RESIN COMPOSITION, AND PREPREG, METAL-CLAD LAMINATE, LAMINATED SHEET, AND PRINTED CIRCUIT BOARD EACH USING SAME**

(30) Priority: 13.10.2023 KR 20230136722
(71) Applicant: Doosan Corporation, Seoul 04563 (KR)
(72) Inventor: LEE, Sanghwan, Yongin-si, Gyeonggi-do 16858 (KR); LEE, Eunho, Yongin-si, Gyeonggi-do 16858 (KR); SON, Suji, Yongin-si, Gyeonggi-do 16858 (KR)
(74) Representative: Isarpatent
(86) International application number: PCT/KR2024/015371
(87) International publication number: WO 2025/080003

(57) **Abstract**

The present invention relates to a resin composition, and a prepreg, a metal-clad laminate, a laminated sheet, and a printed circuit board using the same, wherein the resin composition comprises: (a) an epoxy resin containing a modified dicyclopentadiene (DCPD) epoxy resin; (b) an aliphatic benzoxazine-based resin; and (c) a curing agent.

## Description

### [TECHNICAL FIELD]

The present invention relates to a resin composition, and a prepreg, a metal-clad laminate, a laminated sheet, and a printed circuit board using the same, and more particularly, to a resin composition having a low modulus after curing, a high glass transition temperature, and a low occurrence of surface stickiness, and to a prepreg, a metal-clad laminate, a laminated sheet, and a printed circuit board using the same.

### [BACKGROUND ART]

As 5G technology develops, there is a trend toward applying this technology in the automotive field. The level of reliability required in the automotive field exceeds general levels, and especially when integrated with 5G where data collection and processing are crucial, failures must not occur during the processing. As a result, standards for solder reliability between a semiconductor chip and a main board are becoming higher. However, due to characteristics of materials, the coefficient of thermal expansion (CTE) among the chip, the solder, and the main board is mismatched. In addition, there is a demand for improvement in solder crack characteristics due to vibration, which is a harsh external environment.

### [SUMMARY OF THE INVENTION]

### [TECHNICAL PROBLEM]

The present invention provides a resin composition having a low modulus after curing, a high glass transition temperature, and low surface stickiness, and a prepreg, a metal-clad laminate, a laminated sheet, and a printed circuit board using the same.

### [TECHNICAL SOLUTION]

To achieve the above object, the present invention provides a resin composition comprising (a) an epoxy resin containing a modified dicyclopentadiene (DCPD) epoxy resin; (b) an aliphatic benzoxazine-based resin; and (c) a curing agent.

In one example of the present invention, the modified dicyclopentadiene epoxy resin may be an isocyanate-modified dicyclopentadiene epoxy resin.

In one example of the present invention, the modified dicyclopentadiene epoxy resin may have a modification rate of 5 to 30%.

In one example of the present invention, the modified dicyclopentadiene epoxy resin may have an epoxy equivalent weight of 200 to 400 g/eq.

In one example of the present invention, the epoxy resin may further contain at least one non-dicyclopentadiene epoxy resin selected from the group consisting of a bisphenol-type epoxy resin, a novolac-type epoxy resin, a biphenyl-type epoxy resin, a biphenyl aralkyl-type epoxy resin, an arylalkylene-type epoxy resin, a naphthalene-type epoxy resin, an anthracene-type epoxy resin, a phenoxy-type epoxy resin, a norbornene-type epoxy resin, an adamantane-type epoxy resin, and a fluorene-type epoxy resin.

In one example of the present invention, the modified dicyclopentadiene epoxy resin and the non-dicyclopentadiene epoxy resin may be contained in a weight ratio of 40:60 to 85:15.

In one example of the present invention, the epoxy resin may further contain a dicyclopentadiene-type epoxy resin.

In one example of the present invention, the curing agent may contain a phenol-based curing agent.

In one example of the present invention, the resin composition may further include at least one selected from the group consisting of an inorganic filler, a flame retardant, and a curing accelerator.

In one example of the present invention, the resin composition may include, based on a total weight of the resin composition, 10 to 30 wt% of the modified dicyclopentadiene epoxy resin; 5 to 25 wt% of the aliphatic benzoxazine-based resin; and 5 to 20 wt% of the curing agent.

In one example of the present invention, the resin composition may have a modulus of 8 GPa or less after curing and a glass transition temperature (Tg) of 140 °C or more.

In addition, the present invention provides a prepreg comprising a fiber substrate and the above-described resin composition impregnated into the fiber substrate.

In addition, the present invention provides a metal-clad laminate comprising a metal foil substrate and a resin layer formed on one or both surfaces of the metal foil substrate, in which the above-described resin composition is cured.

Furthermore, the present invention provides a laminated sheet comprising a polymer film substrate and a resin layer formed on one or both surfaces of the polymer film substrate, in which the above-described resin composition is cured.

Moreover, the present invention provides a printed circuit board comprising the above-described prepreg or the above-described metal-clad laminate.

### [ADVANTAGEOUS EFFECTS OF THE INVENTION]

Since the resin composition of the present invention has a low modulus and a high glass transition temperature after curing, when applied to a printed circuit board, the resin composition can absorb and resolve solder stress caused by external stimuli such as heat or vibration, thereby improving the reliability of the printed circuit board.

In addition, since the resin composition of the present invention has a low occurrence of stickiness after curing, workability during manufacturing of a printed circuit board may be improved, and resin fallout may be reduced, so that product quality of the printed circuit board may be improved.

The effects according to the present invention are not limited by the contents exemplified above, and more various effects are included in the present specification.

### [MODES FOR CARRYING OUT THE INVENTION]

Hereinafter, the present invention will be described in detail.

All terms (including technical and scientific terms) used in the present specification may be used with meanings commonly understood by those of ordinary skill in the art to which the present invention belongs. Also, terms such as those defined in commonly used dictionaries are not to be interpreted in an idealized or overly formal sense unless expressly so defined herein.

Further, throughout this specification, when a part is stated to "comprise" a component, this means that it may further include other components and does not exclude other components, unless otherwise stated. And 'cured product' means everything formed by curing a composition.

### <Resin composition>

The resin composition according to the present invention can be applied to a printed circuit board and includes (a) an epoxy resin containing a modified dicyclopentadiene (DCPD) epoxy resin; (b) an aliphatic benzoxazine-based resin; and (c) a curing agent, and may further include at least one selected from the group consisting of an inorganic filler, a flame retardant, and a curing accelerator, if necessary.

Specifically, both the modified DCPD epoxy resin and the aliphatic benzoxazine-based resin can lower a modulus of a product, such as a prepreg and the like. In particular, the aliphatic benzoxazine-based resin has superior low-modulus characteristics compared to the modified DCPD. However, when the aliphatic benzoxazine-based resin is used alone, stickiness occurs after semi-curing, making it impossible to use as a product. In addition, when the aliphatic benzoxazine-based resin is used alone, the glass transition temperature (Tg) is low due to the chemical structure of the aliphatic compound, and adhesive strength with metal may be low due to low polarity. On the other hand, when the modified DCPD epoxy resin is used alone, targeted low-modulus characteristics cannot be realized. Accordingly, in the present invention, by using the modified dicyclopentadiene epoxy resin, which is stable against stickiness and can lower the modulus of a product compared to other novolac-based epoxy resins, in combination with the aliphatic benzoxazine-based resin, not only can the low-modulus characteristics of the product be realized, but also the occurrence of stickiness after semi-curing can be prevented and the adhesive strength with metal can be increased.

Hereinafter, each component constituting the resin composition according to the present invention will be described in detail as follows.

### Epoxy resin

In the resin composition according to the present invention, the epoxy resin includes a modified dicyclopentadiene (DCPD) epoxy resin.

The modified dicyclopentadiene (DCPD) epoxy resin is an epoxy resin having a dicyclopentadiene (DCPD) structure in a molecule thereof, and in which a portion of epoxy groups is modified with an isocyanate group. The isocyanate-modified dicyclopentadiene epoxy resin has a larger volume than conventional epoxy resins due to the DCPD structure, thereby realizing low dielectric properties of the resin composition. In addition, as a portion of the epoxy groups is substituted with the isocyanate group in the modified DCPD epoxy resin, the mobility of a chain is improved, thereby improving a glass transition temperature (Tg) of a cured resin product while realizing a low modulus.

According to an example, the modified DCPD epoxy resin may be represented by Chemical Formula 1 below.

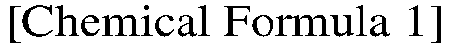

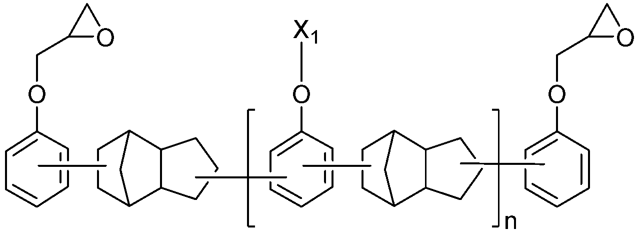

In Chemical Formula 1,
X₁ is an isocyanate group or an epoxy group, provided that at least one of one or a plurality of X₁ is an isocyanate group; and
n is an integer of 1 to 100, specifically an integer of 1 to 50, and more specifically an integer between 1 and 20.

The modified DCPD epoxy resin may have a modification rate in a range of 5 to 30%. Since the modified DCPD epoxy resin has a large volume, excellent chain mobility, and does not decrease in crosslinking density, a cured resin product may exhibit low dielectric properties and simultaneously realize excellent thermal properties and modulus properties.

According to an example, the modified DCPD epoxy resin may have an isocyanate content of 5 to 30 mol% and an epoxy equivalent weight of 200 to 400 g/eq. In this case, a cured product of the resin composition may have a glass transition temperature of about 140 °C or higher and a modulus of about 8 GPa or less.

In the resin composition according to the present invention, a content of the modified DCPD epoxy resin is not particularly limited and may be appropriately adjusted in consideration of physical properties of the resin composition. For example, the modified DCPD epoxy resin may be present in an amount of about 10 to 45 parts by weight, and specifically about 15 to 40 parts by weight, based on 100 parts by weight of the resin composition [that is, components excluding an inorganic filler, a flame retardant, a curing accelerator, and an additive (for example, the epoxy resin component, the benzoxazine-based component, and the curing agent component)].

In the resin composition according to the present invention, the epoxy resin may further include a general-purpose epoxy resin generally known in the art, in addition to the above-described modified DCPD epoxy resin.

For example, the epoxy resin may further include an epoxy resin other than a dicyclopentadiene-type (DCPD-type) epoxy resin (hereinafter, referred to as a "non-DCPD epoxy resin"). By further including the non-DCPD epoxy resin as an epoxy resin component, the resin composition of the present invention may prevent a decrease in adhesive strength.

Non-limiting examples of the non-DCPD epoxy resin include a bisphenol-type epoxy resin (for example, a bisphenol A-type epoxy resin, a bisphenol F-type epoxy resin, a bisphenol S-type epoxy resin, a bisphenol E-type epoxy resin, a bisphenol M-type epoxy resin, a bisphenol P-type epoxy resin, a bisphenol Z-type epoxy resin, and the like), a novolac-type epoxy resin (for example, a phenol novolac-type epoxy resin, a cresol novolac epoxy resin, and the like), a biphenyl-type epoxy resin, a biphenyl aralkyl-type epoxy resin, an arylalkylene-type epoxy resin, a naphthalene-type epoxy resin, an anthracene-type epoxy resin, a phenoxy-type epoxy resin, a norbornene-type epoxy resin, an adamantane-type epoxy resin, a fluorene-type epoxy resin, and the like, and these may be used alone or in combination of two or more types.

According to an example, the non-DCPD epoxy resin may be a bisphenol-type epoxy resin, and specifically a bisphenol A-type epoxy resin.

A use ratio (mixing ratio) of the above-described modified dicyclopentadiene epoxy resin and the non-DCPD epoxy resin may be a weight ratio of 40:60 to 85:15, specifically a weight ratio of 40:60 to 70:30, and more specifically a weight ratio of 55:45 to 70:30.

In the resin composition of the present invention, the epoxy resin may further contain a dicyclopentadiene-type epoxy resin.

A dicyclopentadiene-based (DCPD-type) epoxy resin is a multifunctional epoxy resin having a dicyclopentadiene (DCPD) structure in a molecule thereof, and since it has a hydrophobic double-ring hydrocarbon group and thus has less electronic polarization, it can lower a dielectric constant of a cured resin product.

Examples of the DCPD-type epoxy resin usable in the present invention are not particularly limited as long as they are known in the art, and for example, may be represented by Chemical Formula 2 below.

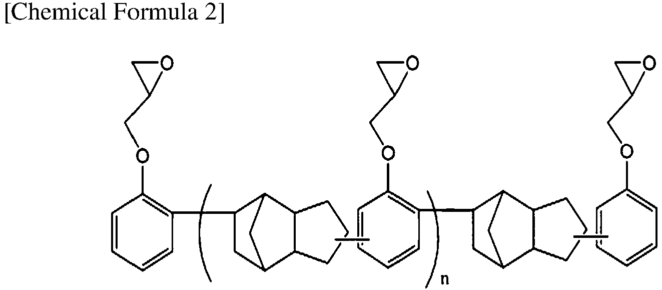

In the above formula, n is an integer of 1 to 10.

A content of the dicyclopentadiene-type epoxy resin is not particularly limited. However, it is appropriate that a total content of the modified DCPD epoxy resin and the DCPD epoxy resin is in a range of about 60 to 80 wt%, and specifically about 65 to 75 wt%, based on a total amount of all epoxy resins. In this case, a use ratio (mixing ratio) of the modified DCPD epoxy resin and the DCPD-type epoxy resin may be a weight ratio of 55:45 to 90:10, and specifically a weight ratio of 55:45 to 87:13.

According to an example, when the epoxy resin contains a modified DCPD epoxy resin, a DCPD epoxy resin, and a bisphenol-type epoxy resin (for example, a bisphenol A-type epoxy resin), a mixing ratio of a) a total of the modified dicyclopentadiene epoxy resin and the DCPD epoxy resin to b) the bisphenol-type epoxy resin may be a weight ratio of 60:40 to 80:20. In this case, a use ratio (mixing ratio) of the modified dicyclopentadiene epoxy resin and the DCPD epoxy resin may be a weight ratio of 40:60 to 90:10, and specifically a weight ratio of 55:45 to 90:10.

### Aliphatic benzoxazine-based resin

The resin composition according to the present invention contains an aliphatic benzoxazine-based resin.

The aliphatic benzoxazine-based resin is a resin having a benzoxazine structure in a molecular structure thereof and having an aliphatic group (for example, an alkylene group or the like) between benzoxazine functional groups in a skeleton thereof. The aliphatic benzoxazine-based resin forms a resin layer together with an epoxy resin through ring-opening polymerization of a benzoxazine ring in a molecule, and has excellent flexibility due to the presence of an aliphatic group in a skeleton, thereby lowering a modulus of the resin layer (a cured product of the resin composition). In addition, when the aliphatic benzoxazine-based resin reacts with a modified DCPD epoxy resin, it can form a cured product having high crosslinking density and excellent flame retardancy and toughness.

According to an example, the aliphatic benzoxazine-based resin may be a resin represented by Chemical Formula 3 below.

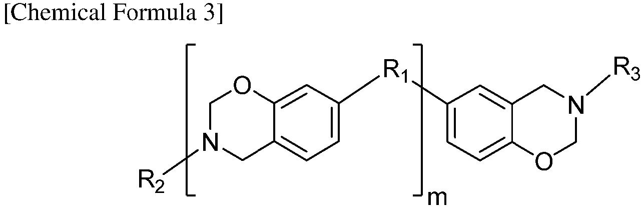

In Chemical Formula 3,
m is an integer of 1 to 10;
R₁ is selected from the group consisting of a C₁ to C₄₀ alkylene group, a C₂ to C₄₀ alkenylene group, and a C₂ to C₄₀ alkynylene group;
R₂ and R₃ are the same as or different from each other, and are each independently selected from the group consisting of hydrogen, a C₁ to C₄₀ alkyl group, a C₂ to C₄₀ alkenyl group, a C₂ to C₄₀ alkynyl group, and a C₆ to C₄₀ aryl group; and
the alkylene group, the alkenylene group, and the alkynylene group of R₁, and the alkyl group, the alkenyl group, the alkynyl group, and the aryl group of R₂ and R₃ may each be independently substituted or unsubstituted with at least one substituent selected from the group consisting of deuterium, halogen, and a cyano group.

In the resin composition according to the present invention, a content of the aliphatic benzoxazine-based resin may be about 10 to 45 parts by weight, and specifically about 15 to 40 parts by weight, based on 100 parts by weight of the resin composition (excluding an inorganic filler, a flame retardant, a curing accelerator, and an additive). If the content of the aliphatic benzoxazine-based resin is less than 10 parts by weight, low-modulus characteristics may not be realized. On the other hand, when the content of the aliphatic benzoxazine-based resin exceeds 45 parts by weight, stickiness may occur after semi-curing.

Meanwhile, the resin composition according to the present invention may further include a benzoxazine-based compound in addition to the aliphatic benzoxazine-based resin.

The benzoxazine-based compound usable in the present invention is not particularly limited as long as it is known in the art, and for example, may be a benzoxazine compound represented by Chemical Formula 4 below.

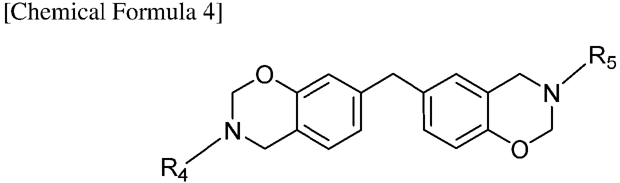

In the formula,
R₄ and R₅ are the same as or different from each other, and are each independently selected from the group consisting of hydrogen, a C₁ to C₄₀ alkyl group, and a C₆ to C₄₀ aryl group; and
the alkyl group and the aryl group of R₄ and R₅ may each be independently substituted or unsubstituted with at least one substituent selected from the group consisting of deuterium, halogen, and a cyano group.

A content of the benzoxazine-based compound is not particularly limited. However, it is appropriate that a total content of the benzoxazine-based compound and the aliphatic benzoxazine-based resin is about 10 to 45 parts by weight, and specifically about 15 to 40 parts by weight, based on 100 parts by weight of a mixture of the epoxy resin, the aliphatic benzoxazine-based resin, the benzoxazine-based compound, and the curing agent. In this case, a use ratio (mixing ratio) of the aliphatic benzoxazine-based resin and the benzoxazine-based compound may be a weight ratio of 55:45 to 70:30, specifically a weight ratio of 55:45 to 65:35, and more specifically a weight ratio of 55:45 to 60:40.

### Curing agent

The resin composition according to the present invention includes a curing agent.

Curing agents usable in the present invention include curing agent components commonly known in the art, for example, an acid anhydride-based curing agent, an amine-based curing agent, a phenol-based curing agent, and the like.

Non-limiting examples of the curing agent include acid anhydride-based curing agents such as tetrahydrophthalic anhydride, methyl tetrahydrophthalic anhydride, methyl hexahydrophthalic anhydride, hexahydrophthalic anhydride, trialkyl tetrahydrophthalic anhydride, methyl cyclohexenedicarboxylic anhydride, phthalic anhydride, maleic anhydride, and pyromellitic anhydride; aromatic amine-based curing agents such as meta-phenylenediamine, diaminodiphenylmethane, and diaminodiphenylsulfone; aliphatic amine-based curing agents such as diethylenetriamine and triethylenetetraamine; phenolic curing agents such as a phenol aralkyl-type phenol resin, a phenol novolac-type phenol resin, a xyloc-type phenol resin, a cresol novolac-type phenol resin, a naphthol-type phenol resin, a terpene-type phenol resin, a multifunctional phenol resin, a dicyclopentadiene-based phenol resin, a naphthalene-type phenol resin, and a novolac-type phenol resin synthesized from bisphenol A and resol; and latent curing agents such as dicyandiamide, but are not limited thereto. These may be used alone or in combination of two or more types.

According to an example, the curing agent may be a phenolic curing agent, and specifically a phenol novolac-type phenol resin. The phenolic curing agent may compensate for a glass transition temperature (Tg) that is lowered due to an aliphatic backbone of the aliphatic benzoxazine-based resin.

A content of the curing agent may be about 10 to 20 wt%, and specifically about 13 to 18 wt%, based on 100 parts by weight of the resin composition (excluding an inorganic filler, a flame retardant, a curing accelerator, and an additive).

### Inorganic filler

The resin composition according to the present invention may further include a conventional inorganic filler known in the art, if necessary.

The inorganic filler may effectively improve warpage characteristics, low expansion, mechanical strength (toughness), and low stress of a final product by reducing a difference in coefficient of thermal expansion (CTE) between a resin layer and other layers while increasing mechanical properties.

Non-limiting examples of usable inorganic fillers include silicas such as natural silica, fused silica, amorphous silica, and crystalline silica; boehmite, alumina, talc, spherical glass, calcium carbonate, magnesium carbonate, magnesia, clay, calcium silicate, titanium oxide, antimony oxide, glass fiber, aluminum borate, barium titanate, strontium titanate, calcium titanate, magnesium titanate, bismuth titanate, titanium oxide, barium zirconate, calcium zirconate, boron nitride, silicon nitride, talc, mica, and the like. These inorganic fillers may be used alone or in combination of two or more types. Among the inorganic fillers, silica exhibiting a low coefficient of thermal expansion is preferable.

A size of the inorganic filler is not particularly limited, but in consideration of dispersibility, an average particle diameter (D₅₀) may be about 0.5 to 5 *µ*m.

In addition, the inorganic filler may have a surface treated with a silane coupling agent. As the silane coupling agent, conventional components known in the art may be used, and those containing a vinyl group and/or an allyl group may be used. When surface-treated with such a silane coupling agent, compatibility with a resin is excellent, so that dielectric properties, heat resistance, processability, and the like of the resin composition may be improved.

In the present invention, a content of the inorganic filler is not particularly limited and may be appropriately adjusted in consideration of the warpage characteristics, mechanical properties, and the like described above. However, if the content of the inorganic filler is excessive, it may be detrimental to moldability. For example, the content may be about 50 to 200 parts by weight, and specifically about 60 to 180 parts by weight, based on 100 parts by weight of the resin composition (excluding an inorganic filler, a flame retardant, a curing accelerator, and an additive).

### Flame retardant

The resin composition according to the present invention may further include a flame retardant, if necessary.

As the flame retardant, conventional ones known in the art may be used without limitation to increase flame retardancy. For example, halogen flame retardants containing bromine or chlorine; phosphorus-based flame retardants such as phosphate, phosphonate, phosphinate, phosphine oxide, and phosphazene; antimony-based flame retardants such as antimony trioxide; and inorganic flame retardants such as metal hydroxides such as aluminum hydroxide and magnesium hydroxide, and the like may be used. It is preferable to use a phosphorus-based flame retardant that does not deteriorate heat resistance and dielectric properties, and specific examples thereof include triphenyl phosphate, tricresyl phosphate, trisdichloropropyl phosphate, phosphazene, and the like.

In the present invention, a content of the flame retardant is not particularly limited and may be appropriately adjusted within a content range known in the art. Considering the physical properties of the resin composition according to the present invention, the content may be about 5 to 25 parts by weight, and specifically about 7 to 20 parts by weight, based on 100 parts by weight of the resin composition (excluding an inorganic filler, a flame retardant, a curing accelerator, and an additive).

### Curing accelerator

In the present invention, a conventional curing accelerator known in the art may be further included, if necessary.

The curing accelerator may be appropriately selected and used according to types of the epoxy resin and the curing agent. Non-limiting examples of usable curing accelerators include amine-based, phenol-based, and imidazole-based curing accelerators, and specific examples thereof include an amine complex of boron trifluoride, an imidazole derivative, and organic acids such as phthalic anhydride and trimellitic anhydride. As a preferable example of a usable catalyst, there is an imidazole derivative curing accelerator, and specifically, 1-methylimidazole, 2-methylimidazole, 2-ethyl-4-methylimidazole, 2-phenylimidazole, 2-phenyl-4-methylimidazole, cyanoethylation derivatives thereof, carboxylic acid derivatives thereof, hydroxymethyl group derivatives thereof, and the like. The aforementioned catalysts may be used alone or in combination of two or more types.

In addition, organometallic salts or organometallic complexes containing at least one metal selected from the group consisting of iron, copper, zinc, cobalt, lead, nickel, manganese, and tin may be used. Specific examples of usable organometallic salts or organometallic complexes include iron naphthenate, copper naphthenate, zinc naphthenate, cobalt naphthenate, nickel naphthenate, manganese naphthenate, tin naphthenate, zinc octanoate, tin octanoate, iron octanoate, copper octanoate, zinc 2-ethylhexanoate, lead acetylacetonate, cobalt acetylacetonate, dibutyltin maleate, and the like, which may be used alone or in combination of two or more types.

In the present invention, a content of the curing accelerator is not particularly limited and may be appropriately adjusted within a content range known in the art. Considering the physical properties of the resin composition, the content of the curing accelerator may be about 0.1 to 10 parts by weight, specifically about 0.5 to 10 parts by weight, and more specifically about 0.5 to 7 parts by weight, based on 100 parts by weight of the resin composition (excluding an inorganic filler, a flame retardant, a curing accelerator, and an additive).

### Additives

The resin composition according to the present invention may further include, if necessary, various polymers such as other thermosetting resins, thermoplastic resins, and oligomers thereof not described above, solid rubber particles, or other additives such as an ultraviolet absorber, an antioxidant, a polymerization initiator, a dye, a pigment, a dispersant, a thickener, a leveling agent, and the like, as long as inherent characteristics of the resin composition are not impaired.

For example, organic fillers such as silicone powder, nylon powder, and fluorine powder; thickeners such as olben and bentone; silicone-based, fluorine-based, or polymer-based antifoaming agents or leveling agents; adhesion-imparting agents such as imidazole-based, thiazole-based, triazole-based agents, silane coupling agents, epoxysilane, aminosilane, alkylsilane, and mercaptosilane; coloring agents such as phthalocyanine blue, phthalocyanine green, iodine green, disazo yellow, and carbon black; release agents such as higher fatty acids, higher fatty acid metal salts, and ester waxes; and stress relaxation agents such as modified silicone oil, silicone powder, and silicone resin, and the like are included. In addition, additives commonly used in thermosetting resin compositions used in the production of electronic devices (particularly, printed wiring boards) may be included.

The resin composition may further contain a thermoplastic resin for the purpose of imparting appropriate flexibility to the resin composition after curing, and the like. Non-limiting examples of usable thermoplastic resins include a phenoxy resin, a polyvinyl acetal resin, a polyimide, a polyamideimide, a polyethersulfone, a polysulfone, and the like. Any one type of these thermoplastic resins may be used alone, or two or more types thereof may be used in combination.

A content of the additive is not particularly limited, and may be, for example, about 0.01 to 10 parts by weight, and specifically about 0.1 to 5 parts by weight, based on 100 parts by weight of the resin composition.

The resin composition of the present invention described above has a low modulus after curing and a high glass transition temperature, and thus, when applied to a printed circuit board, the resin composition may absorb and resolve solder stress caused by external stimuli such as heat or vibration, thereby improving the reliability of the printed circuit board. In addition, since the resin composition of the present invention has a low occurrence of stickiness after curing, workability during manufacturing of a printed circuit board may be improved, and resin fallout may be reduced, so that product quality of the printed circuit board may be improved.

According to an example, the resin composition of the present invention may have a modulus of about 8 GPa or less, specifically about 5 to 8 GPa, after curing, and a glass transition temperature (Tg) of 140 °C or higher, specifically about 140 to 170 °C.

### <Prepreg>

One embodiment of the present invention is a prepreg comprising the above-described resin composition or a cured product thereof. Such a prepreg is distinguished from conventional prepregs in that the prepreg contains the resin composition having the above-described composition, and may be used for a printed circuit board to be described later.

As a specific example of the prepreg, the prepreg includes a fiber substrate and the above-described resin composition impregnated into the fiber substrate. Here, the resin composition may be a resin varnish in a form dissolved or dispersed in a solvent, or a cured product of the resin composition. The cured product includes all of an uncured product, a semi-cured product, and/or a fully cured product.

The fiber substrate includes a flexible inorganic fiber substrate, organic fiber substrate, or a mixed form thereof, which is commonly used in the art and is arbitrarily bendable. The fiber substrate may be arbitrarily selected based on the intended use or performance.

Non-limiting examples of usable fiber substrates include glass fibers (inorganic fibers) such as E-glass, D-glass, S-glass, NE-glass, T-glass, Q-glass, and the like; organic fibers such as glass paper, a glass web, glass cloth, an aramid fiber, aramid paper, polyimide, polyamide, polyester, aromatic polyester, a fluororesin, and the like; and a carbon fiber, paper, an inorganic fiber, or a mixed form of at least one type thereof. The form of the fiber substrate includes a woven fabric or a nonwoven fabric made of the aforementioned fibers or the like; and a woven fabric, a nonwoven fabric, mats, and the like made of roving, a chopped strand mat, a surfacing mat, a metal fiber, a carbon fiber, a mineral fiber, and the like. These substrates may be used alone or in combination of two or more types. When reinforced fiber substrates are used in combination, the rigidity and dimensional stability of the prepreg may be improved. The thickness of the fiber substrate is not particularly limited and may range from about 0.01 mm to 0.3 mm, for example.

The prepreg according to the present invention may be manufactured according to a method known in the art. As a specific example, the prepreg refers to a sheet-shaped material in which a sheet-like fiber substrate or glass substrate made of fibers is coated or impregnated with the resin composition or a resin composition varnish and then cured to a B-stage (semi-cured state) by heating to impregnate the resin into the fiber substrate. In this case, a temperature and time for heating the fiber substrate impregnated with the resin composition of the present invention are not particularly limited, and for example, the temperature may be about 150 to 210 °C and the time may be about 3 to 10 minutes.

In addition to the aforementioned method, the prepreg of the present invention may also be manufactured by a method such as a solvent method, a hot melt method, and the like.

The solvent method is a method in which the fiber substrate is impregnated with a resin composition varnish formed by dissolving a resin composition for forming a prepreg in an organic solvent, and then dried. When employing such a solvent method, a resin varnish is generally used. As an example of a method for impregnating the fiber substrate with the resin composition, a method of immersing the substrate in a resin varnish, a method of applying the resin varnish to the substrate by various coaters, a method of spraying the resin varnish onto the substrate by a spray, and the like may be used. In this case, the method of immersing the fiber substrate in the resin varnish is preferable because it can improve the impregnation property of the resin composition into the fiber substrate. Examples of organic solvents usable in preparing the resin composition varnish include ketones such as acetone, methyl ethyl ketone, and cyclohexanone; acetic acid esters such as ethyl acetate, butyl acetate, cellosolve acetate, propylene glycol monomethyl ether acetate, and carbitol acetate; carbitols such as cellosolve and butyl carbitol; aromatic hydrocarbons such as toluene and xylene; and dimethylformamide, dimethylacetamide, N-methylpyrrolidone, tetrahydrofuran, and the like. The aforementioned organic solvents may be used alone or in combination of two or more types.

In addition, the hot melt method may be a method of coating the resin composition on a release paper having excellent peelability without dissolving the resin composition in an organic solvent, and then laminating it on a sheet-like fiber substrate or directly coating it by a die coater. In addition, it may be manufactured by disposing an adhesive film made of the resin composition on both surfaces of a sheet-like fiber substrate, and then continuously laminating the same by heating and pressing.

Since the prepreg of the present invention includes a resin in which the above-described resin composition is cured, the prepreg may exhibit excellent adhesiveness, heat resistance, and a glass transition temperature, as well as improved low-dielectric properties and cost reduction effects.

### <Metal-clad laminate >

One embodiment of the present invention is a metal-clad laminate (a metal foil laminate) comprising the above-described resin composition or a cured product thereof.

As a specific example, the metal-clad laminate includes a metal foil substrate and a resin layer formed on one or both surfaces of the metal foil substrate, in which the above-described resin composition is cured.

For the metal foil, any metal or alloy known in the art may be used without limitation. When the metal foil is a copper foil, the metal-clad laminate formed by coating and drying the resin composition according to the present invention may be used as a copper-clad laminate (CCL). The metal foil may preferably be a copper foil.

Such a copper foil includes all copper foils manufactured by a rolling method and an electrolysis method. The copper foil may be treated with an anti-rust treatment to prevent a surface from being oxidized and corroded. Non-limiting examples of usable copper foils include CFL (TZA_B, HFZ_B), Mitsui (HSVSP, MLS-G), Nikko (RTCHP), Furukawa, ILSIN, and the like.

In the present invention, the metal foil may have a predetermined surface roughness (Rz) formed on a surface thereof that comes into contact with the cured resin layer of the resin composition. A range of the surface roughness (Rz) is not particularly limited, and may be, for example, about 0.5 to 5 µm, and specifically about 0.5 to 3 µm.

In addition, a thickness of the metal foil is not particularly limited, and in consideration of a thickness and mechanical properties of a laminated sheet, the thickness may be about 35 µm or less, and specifically about 1 to 18 µm.

### <Laminated sheet>

Another embodiment of the present invention is a laminated sheet comprising the above-described resin composition or a cured product thereof.

As a specific example, the laminated sheet includes a polymer film substrate and a resin layer formed on one or both surfaces of the polymer film substrate, in which the above-described resin composition is cured.

The polymer film substrate is not particularly limited as long as the polymer film substrate is an insulating film known in the art. Non-limiting examples of usable polymer film substrates include polyester films such as polyethylene terephthalate (PET), polybutylene terephthalate, and polyethylene naphthalate; a polyethylene film; a polypropylene film; cellophane; a diacetyl cellulose film; a triacetyl cellulose film; an acetyl cellulose butyrate film; a polyvinyl chloride film; a polyvinylidene chloride film; a polyvinyl alcohol film; an ethylenevinyl acetate copolymer film; a polystyrene film; a polycarbonate film; a polymethylpentene film; a polysulfone film; a polyetheretherketone film; a polyethersulfone film; a polyetherimide film; a polyimide (PI) film; a fluororesin film; a polyamide film; an acrylic resin film; a norbornene-based resin film; a cycloolefin resin film; and the like. Specifically, the polymer film substrate may be a polyimide (PI) film, an epoxy resin film, a PET (polyethylene terephthalate) film, a PEN (polyethylene naphthalate) film, or the like. These polymer films may be any of transparent or translucent, and may be colored or uncolored, and may be appropriately selected depending on the intended use. In addition, the polymer film substrate may be a substrate in which a silicone release treatment, an antistatic treatment, or both the silicone release treatment and the antistatic treatment are performed on at least one surface.

A thickness of the polymer film substrate is not particularly limited, and may be 1 to 100 µm, and specifically 10 to 80 µm, in consideration of a thickness and mechanical properties of the laminated sheet.

### <Printed circuit board>

Another embodiment of the present invention is a printed circuit board including the prepreg or the metal-clad laminate described above.

As a specific example, the printed circuit board includes a laminate formed by overlapping two or more prepregs described above and then heating and pressing the same under normal conditions. Such a laminate serves as an insulating layer, an adhesive layer, a coverlay layer, or the like in a printed circuit board.

The printed circuit board according to the present invention may be manufactured according to a method known in the art. As an embodiment, the printed circuit board may be manufactured by laminating a copper foil on one or both surfaces of the prepreg described above, heating and pressing the same to form a copper-clad laminate, forming a through hole in the copper-clad laminate, performing through-hole plating, and then etching the copper foil to form a circuit.

The printed circuit board of the present invention configured as described above may have improved reliability because it is manufactured using a prepreg or a metal-clad laminate including a resin in which a resin composition containing an epoxy resin containing a modified DCPD epoxy resin, an aliphatic benzoxazine-based resin, and a curing agent is cured. Accordingly, the printed circuit board of the present invention may be usefully used as a printed circuit board and/or a material thereof applied to various electric and electronic devices such as a mobile communication device or a base station device thereof, a server, a network-related electronic device such as a router, and a large computer.

Hereinafter, the present invention will be described in detail through Examples. However, the following Examples are only for illustrating the present invention, and the present invention is not limited by the following Examples.

### <Examples 1 to 4>

### Preparation of resin composition

Each component was mixed according to the compositions described in Tables 1 and 2 below to prepare a resin composition. In this case, a unit of a content (amount used) of each component in Table 2 below is parts by weight, and is based on 100 parts by weight of the resin composition (excluding an inorganic filler, a flame retardant, a curing accelerator, and an additive).

### Preparation of prepreg

After the prepared resin composition was impregnated into glass fiber, it was dried and heated at 170 °C for 4 minutes to prepare a prepreg in a B-stage (semi-cured) state.

### Preparation of copper-clad laminate

After laminating 1 ply of the prepreg prepared in Example 1-2 on a copper foil, the same was pressed at 200 °C for 3 hours to prepare a copper-clad laminate having a thickness of 70 mm.

### Preparation of printed circuit board

After a photosensitive dry film was applied to the copper-clad laminate prepared in Example 1-3 by adhering the same with heat and pressure, light was irradiated using a master film on which a circuit is displayed, and a printed circuit board (PCB) was prepared through development. On a surface of the completed printed circuit board, copper foil including an unnecessary plating film was removed (etched) with a highly corrosive chemical to form a circuit.

**[Table 1]**

| Configuration | | | Detailed specifications |
|---|---|---|---|
| Epoxy resin components | A-1 | Modified DCPD | KDCP-300 (Kukdo Chemical Co., Ltd.) (isocyanate content: 10 mol%, epoxy equivalent weight: 300 g/eq) |
| | A-2 | DCPD | XD-1000 (Nippon Kayaku Co., Ltd.) |
| | A-3 | Bisphenol A-type epoxy resin | YD-127 (Kukdo Chemical Co., Ltd.) |
| Benzoxazine component | B-1 | Aliphatic benzoxazine-based resin | KZH-5084 (Kolon Industries, Inc.) |
| | B-2 | Benzoxazine | KSB-6090F (Kangnam Chemical Co., Ltd.) |
| Curing agent | C | Phenol novolac-type curing agent | KPN-2125 (Kangnam Chemical Co., Ltd.) |
| Inorganic filler | D | Silica | SC-2050MNS (Admatechs Co., Ltd.) |
| Flame retardant | E | Phosphorus-based flame retardant | PX-200 (Daihachi Chemical Industry Co., Ltd.) |

**[Table 2]**

| | Example | | | | Comparative Example | | | |
|---|---|---|---|---|---|---|---|---|
| | 1 | 2 | 3 | 4 | 1 | 2 | 3 | 4 |
| A-1 | 35 | 20 | 35 | 30 | - | 35 | - | - |
| A-2 | - | 15 | - | 5 | 35 | - | 35 | 20 |
| A-3 | 15 | 15 | 15 | 15 | 15 | 15 | 15 | 15 |
| B-1 | 35 | 35 | 20 | 20 | - | - | 35 | 50 |
| B-2 | - | - | 15 | 15 | 35 | 35 | - | - |
| C | 15 | 15 | 15 | 15 | 15 | 15 | 15 | 15 |
| D | 40 | 40 | 40 | 40 | 40 | 40 | 40 | 40 |
| E | 10 | 10 | 10 | 10 | 10 | 10 | 10 | 10 |

### <Comparative Examples 1 to 4>

A resin composition, a prepreg, a copper-clad laminate, and a printed circuit board were each manufactured in the same manner as in Example 1, except that the compositions were changed as described in Table 2 above.

### <Experimental Example 1> - Evaluation of Physical Properties

Physical properties of the printed circuit boards manufactured in Examples 1 to 4 and Comparative Examples 1 to 4 were evaluated by the following methods, and the results thereof are shown in Table 3 below.

### 1) Adhesion of copper foil (Peel Strength, P/S)

According to the evaluation standard of IPC-TM-650 2.4.8, a copper foil layer of the printed circuit board was pulled up in a 90° direction, and a point at which the copper foil layer was peeled off was measured and evaluated.

### 2) Glass transition temperature (Tg)

The glass transition temperature (Tg) was measured by IPC-TM-650-2.4.24.4 (DMA Method) using Q800 of TA Instruments (Dynamic Mechanical Analysis).

### 3) Modulus (GPa)

The modulus was measured by IPC-TM-650-2.4.4 (Flexural Strength of Laminates Method) using a Universal Testing Machine (UTM) (Instron 5967, manufactured by Instron).

### 4) Stickiness (sticky)

After preparing four prepregs each having a size of 5 cm × 5 cm, the prepregs were laminated and then vacuum-packed in vinyl. Thereafter, a SUS plate (size: 10 cm × 10 cm, weight: 300 g) was placed on the vacuum-packed laminate, and left for 2 hours at a temperature of 35 °C and a humidity of 50 %RH. After 2 hours, the vinyl packaging was removed from the vacuum-packed laminate, and then whether stickiness (adhesion) between the laminated prepregs occurred was checked. At this time, when fallout of resin occurred, it was judged to have stickiness and indicated as "NG", and when there was no fallout of resin, it was judged to have no stickiness and indicated as "OK".

**[Table 3]**

| | Example | | | | Comparative Example | | | |
|---|---|---|---|---|---|---|---|---|
| | 1 | 2 | 3 | 4 | 1 | 2 | 3 | 4 |
| P/S(kgf/cm) | 0.85 | 0.90 | 0.90 | 1.00 | 1.10 | 1.05 | 0.95 | 0.75 |
| Tg(°C)(DMA) | 140 | 145 | 155 | 165 | 185 | 170 | 160 | 135 |
| Modulus (GPa) | 6 | 7 | 7.5 | 8 | 16 | 14 | 11 | 10 |
| Stickiness | OK | OK | OK | OK | OK | OK | OK | NG |

As a result of the experiment, Examples 1 to 4 including the modified DCPD epoxy resin and the aliphatic DCPD exhibited superior effects in terms of glass transition temperature (Tg), adhesiveness, modulus properties, and resistance to stickiness compared to Comparative Examples 1 to 4 that did not simultaneously include the aforementioned components.

## Claims

1. A resin composition comprising:
(a) an epoxy resin containing a modified dicyclopentadiene (DCPD) epoxy resin;
(b) an aliphatic benzoxazine-based resin; and
(c) a curing agent.

2. The resin composition according to claim 1, wherein
the modified dicyclopentadiene epoxy resin is an isocyanate-modified dicyclopentadiene epoxy resin.

3. The resin composition according to claim 1, wherein
the modified dicyclopentadiene epoxy resin is an epoxy resin represented by Chemical Formula 1 below: 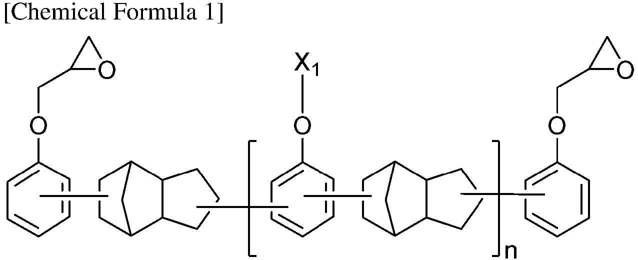 (wherein, in Chemical Formula 1,
X₁ is an isocyanate group or an epoxy group, provided that at least one of one or a plurality of X₁ is an isocyanate group; and
n is an integer of 1 to 100).

4. The resin composition according to claim 1, wherein
the modified dicyclopentadiene epoxy resin has a modification rate in a range of 5 to 30%.

5. The resin composition according to claim 1, wherein
the modified dicyclopentadiene epoxy resin has an epoxy equivalent weight of 200 to 400 g/eq.

6. The resin composition according to claim 1, wherein
the epoxy resin further contains at least one non-dicyclopentadiene epoxy resin selected from the group consisting of a bisphenol-type epoxy resin, a novolac-type epoxy resin, a biphenyl-type epoxy resin, a biphenyl aralkyl-type epoxy resin, an arylalkylene-type epoxy resin, a naphthalene-type epoxy resin, an anthracene-type epoxy resin, a phenoxy-type epoxy resin, a norbornene-type epoxy resin, an adamantane-type epoxy resin, and a fluorene-type epoxy resin.

7. The resin composition according to claim 6, wherein
the modified dicyclopentadiene epoxy resin and the non-dicyclopentadiene epoxy resin are contained in a weight ratio of 40:60 to 85:15.

8. The resin composition according to claim 6, wherein
the epoxy resin further contains a dicyclopentadiene-type epoxy resin.

9. The resin composition according to claim 1, wherein
the aliphatic benzoxazine-based resin is a compound represented by Chemical Formula 3 below: 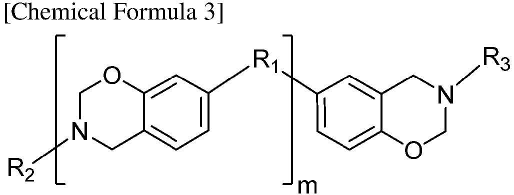 (wherein, in Chemical Formula 3,
m is an integer of 1 to 10;
R₁ is selected from the group consisting of a C₁ to C₄₀ alkylene group, a C₂ to C₄₀ alkenylene group, and a C₂ to C₄₀ alkynylene group;
R₂ and R₃ are the same as or different from each other, and are each independently selected from the group consisting of hydrogen, a C₁ to C₄₀ alkyl group, a C₂ to C₄₀ alkenyl group, a C₂ to C₄₀ alkynyl group, and a C₆ to C₄₀ aryl group; and
the alkylene group, the alkenylene group, and the alkynylene group of R₁, and the alkyl group, the alkenyl group, the alkynyl group, and the aryl group of R₂ and R₃ are each independently substituted or unsubstituted with at least one substituent selected from the group consisting of deuterium, halogen, and a cyano group).

10. The resin composition according to claim 1, wherein
the curing agent contains a phenol-based curing agent.

11. The resin composition according to claim 1, further comprising at least one selected from the group consisting of an inorganic filler, a flame retardant, and a curing accelerator.

12. The resin composition according to claim 1,
comprising, based on a total weight of the resin composition:
10 to 30 wt% of the modified dicyclopentadiene epoxy resin;
5 to 25 wt% of the aliphatic benzoxazine-based resin; and
5 to 20 wt% of the curing agent.

13. The resin composition according to claim 1, wherein
the resin composition has
a modulus of 8 GPa or less after curing, and
a glass transition temperature (Tg) of 140 °C or higher.

14. A prepreg comprising: a fiber substrate; and
the resin composition according to any one of claims 1 to 13 impregnated into the fiber substrate.

15. A metal-clad laminate comprising: a metal foil substrate; and
a resin layer formed on one or both surfaces of the metal foil substrate, in which the resin composition according to any one of claims 1 to 13 is cured.

16. A laminated sheet comprising: a polymer film substrate; and
a resin layer formed on one or both surfaces of the polymer film substrate, in which the resin composition according to any one of claims 1 to 13 is cured.

17. A printed circuit board comprising the prepreg according to claim 14 or the metal-clad laminate according to claim 15.
